# EUROPEAN PATENT APPLICATION

(11) **EP 4 557 920 A1**
(43) Date of publication of application: **21.05.2025**
(21) Application number: 24211135.9
(22) Date of filing: 06.11.2024
(51) Int. Cl.: H10K 59/121, H10K 59/80, H10K 50/844, H10K 59/65

(54) **DISPLAY DEVICE AND MANUFACTURING METHOD THEREOF**

(30) Priority: 14.11.2023 KR 20230157172
(71) Applicant: LG Display Co., Ltd., Seoul 07336 (KR)
(72) Inventor: MOON, Youngkyun, 10845 Paju-si, Gyeonggi-do (KR); KIM, MinJoo, 10845 Paju-si, Gyeonggi-do (KR); CHU, Dongil, 10845 Paju-si, Gyeonggi-do (KR)
(74) Representative: Viering, Jentschura & Partner mbB Patent- und Rechtsanwälte

(57) **Abstract**

Discussed is a display device (100) that includes a substrate (301) having a non-display area (NA, OA) having a through-hole (TH) and a display area (AA) adjacent to the non-display area (NA, OA), an insulating layer (308) disposed on the substrate (301), a light emitting stack (352) disposed on the insulating layer (308), an electrode (353) extending from the display area (AA) to the non-display area (NA, OA) and disposed on the light emitting stack (352), and an electrode patterning material layer (420) contacting one end of the electrode (353), and disposed on the light emitting stack (352). One end of the light emitting stack (352) and one end of the electrode patterning material layer (420) can coincide. It is possible to provide a display device (100) capable of preventing or reducing lateral moisture penetration due to a presence of the light emitting stack (352).

## Description

### CROSS-REFERENCE TO RELATED APPLICATION

This application claims priority to Korean Patent Application No. 10-2023-0157172, filed in the Republic of Korea on November 14, 2023.

### BACKGROUND

### Field

Embodiments of the present disclosure relate to a display device and a method of manufacturing the same.

### Discussion of the Related Art

Nowadays, uses of a display device are becoming more and more diverse. In addition, as the display device becomes thinner and lighter, its range of use is expanding to various areas of economic activity.

As a size of a display area for displaying an image in the display device is increased, various functions linked to or combined with the display device are being added to the display device for greater flexibility of use.

As so-called bezel-less or bezel-free designs in which the display area looks full are becoming increasingly common, research on a display device which has, inside a display area, an area not for displaying an image but for adding various functions is required to have greater flexibility of use.

Accordingly, a display device called a hole-in display (HID) or a hole-in active area (HiAA) in which at least a portion of a substrate is removed in the display area of a display panel has been proposed.

However, there is a problem that cracks can occur in the process of removing a portion of the substrate or moisture can penetrate into an area where the substrate is removed, causing deterioration of display quality as well as causing defects in the display device. Therefore, a solution to this problem is required to produce a reliable display device.

### BRIEF SUMMARY OF THE DISCLOSURE

There is a problem that, as moisture, etc. penetrates into an area where a substrate in a display area is removed, display quality deteriorates. Accordingly, the inventors of the present disclosure have invented a display device which prevents or reduces lateral moisture penetration by a light emitting stack.

Embodiments of the present disclosure are directed to providing a display device capable of blocking a lateral moisture penetration path by a light emitting stack by patterning the light emitting stack, and a method of manufacturing the same.

Embodiments of the present disclosure are directed to providing a display device capable of preventing or reducing a lateral moisture penetration path and micro cracks by a light emitting stack by patterning the light emitting stack and disposing a dam structure, and a method of manufacturing the same.

Embodiments of the present disclosure are directed to providing a display device capable of low power consumption by increasing lifespan by preventing or reducing lateral moisture penetration, and a method of manufacturing the same. Various embodiments of the present disclosure provide a display device and a method of manufacturing a display device according to the independent claims. Further embodiments are described in the dependent claims.

According to embodiments of the present disclosure, a display device can include: a substrate including a non-display area which includes a through-hole and a display area which surrounds the non-display area, an insulating layer disposed on the substrate, a light emitting stack disposed on the insulating layer, an electrode (herein also referred to as a second electrode) extending from the display area to the non-display area to be disposed on the light emitting stack, and an electrode patterning material layer contacting one end of the electrode, and disposed on the light emitting stack, wherein one end of the light emitting stack and one end of the electrode patterning material layer are disposed to coincide.

According to embodiments of the present disclosure, a display device can include: a substrate including a non-display area which includes a through-hole and a display area which surrounds the non-display area, an insulating layer disposed on the substrate, a plurality of dams located between the display area and the through-hole, and disposed on the insulating layer, a light emitting stack disposed on the insulating layer and the plurality of dams, an electrode (herein also referred to as a second electrode) extending from the display area to the non-display area to be disposed on the light emitting stack, an electrode patterning material layer contacting one end of the electrode, and disposed on the light emitting stack, and a groove at which each of the light emitting stack and the electrode patterning material layer is cut.

According to embodiments of the present disclosure, a method of manufacturing a display device can include: forming a substrate including a display area and a non-display area, forming a sacrificial layer and a dam in the non-display area, forming a light emitting stack to cover the sacrificial layer and the dam, forming an electrode patterning material layer on the light emitting stack to be located in the non-display area, forming an electrode (herein also referred to as a second electrode) on the light emitting stack to contact the electrode patterning material layer, forming a capping layer on the electrode and the electrode patterning material layer, and forming a groove by irradiating laser light to the sacrificial layer.

According to the embodiments of the present disclosure, it is possible to provide a display device capable of blocking a lateral moisture penetration path due to the presence of a light emitting stack by patterning the light emitting stack, and a method of manufacturing the same.

According to the embodiments of the present disclosure, it is possible to provide a display device capable of preventing or reducing a lateral moisture penetration path and micro cracks by a light emitting stack by patterning the light emitting stack and disposing a dam structure, and a method of manufacturing the same.

According to the embodiments of the present disclosure, it is possible to provide a display device capable of low power consumption by increasing lifespan by preventing or reducing lateral moisture penetration, and a method of manufacturing the same.

### BRIEF DESCRIPTION OF THE DRAWINGS

FIG. 1 is a system configuration diagram of a display device according to embodiments of the present disclosure.
FIG. 2 is an equivalent circuit diagram of a subpixel in a display panel according to the embodiments of the present disclosure.
FIG. 3 is a plan view showing the structure of an optical area of the display panel according to the embodiments of the present disclosure.
FIG. 4 is an example of a cross-sectional view taken along line I-I' of FIG. 3.
FIG. 5 is an example of a cross-sectional view taken along line II-II' of FIG. 3.
FIG. 6 is another example of the cross-sectional view taken along line II-II' of FIG. 3.
FIGS. 7, 8, 9, 10, 11, 12A and 12B are views showing a process of forming an optical area of a display panel according to embodiments of the present disclosure.

### DETAILED DESCRIPTION OF THE EMBODIMENTS

In the following description of examples or embodiments of the present disclosure, reference will be made to the accompanying drawings in which it is shown by way of illustration specific examples or embodiments that can be implemented, and in which the same reference numerals and signs can be used to designate the same or like components even when they are shown in different accompanying drawings from one another. Further, in the following description of examples or embodiments of the present disclosure, detailed descriptions of well-known functions and components incorporated herein will be omitted when it is determined that the description can make the subject matter in some embodiments of the present disclosure rather unclear. The terms such as "including," "having," "containing," "constituting," "make up of" and "formed of" used herein are generally intended to allow other components to be added unless the terms are used with the term "only." As used herein, singular forms are intended to include plural forms unless the context clearly indicates otherwise.

Terms, such as "first," "second," "A," "B," "(A)" or "(B)" can be used herein to describe elements of the present disclosure. Each of these terms is not used to define essence, order, sequence, number of elements, etc., but is used merely to distinguish the corresponding element from other elements.

When it is mentioned that a first element "is connected or coupled to," "contacts or overlaps," etc. a second element, it should be interpreted that, not only can the first element "be directly connected or coupled to" or "directly contact or overlap" the second element, but a third element can also be "interposed" between the first and second elements, or the first and second elements can "be connected or coupled to," "contact or overlap," etc. each other via a fourth element. Here, the second element can be included in at least one of two or more elements that "are connected or coupled to," "contact or overlap," etc. each other.

When time relative terms, such as "after," "subsequent to," "next," "before" and the like, are used to describe processes or operations of elements or configurations, or flows or steps in operating, processing, manufacturing methods, these terms can be used to describe nonconsecutive or non-sequential processes or operations unless the term "directly" or "immediately" is used together.

In addition, when any dimensions, relative sizes, etc. are mentioned, it should be considered that numerical values for elements or features, or corresponding information (e.g., level, range, etc.) include a tolerance or error range that can be caused by various factors (e.g., process factors, internal or external impact, noise, etc.) even when a relevant description is not specified. Further, the term "can" fully encompasses all the meanings of the term "may."

Hereinafter, various embodiments of the present disclosure will be described in detail with reference to accompanying drawings.

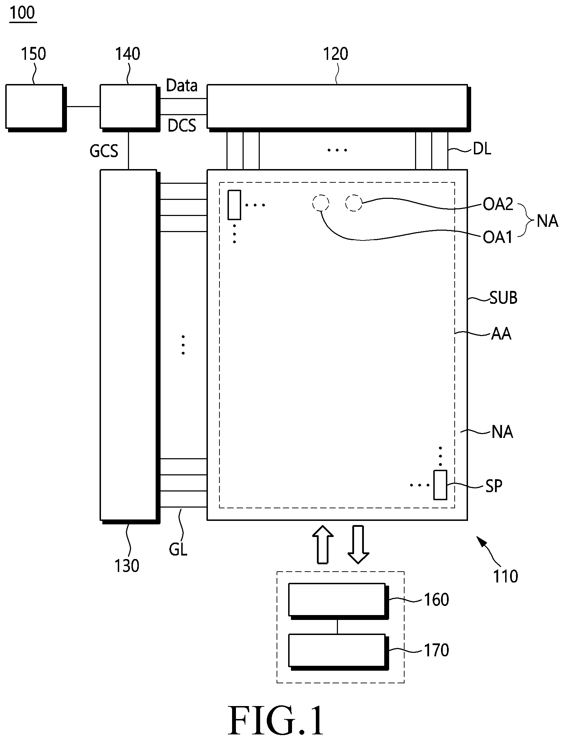

FIG. 1 is a system configuration diagram of a display device 100 according to embodiments of the present disclosure. All components of each display apparatus according to all embodiments of the present disclosure are operatively coupled and configured.

Referring to FIG. 1, the display device 100 can include a display panel 110 and a display driving circuit as components for displaying an image.

The display driving circuit as a circuit for driving the display panel 110 can include a data driving circuit 120, a gate driving circuit 130 and a display controller 140.

The display panel 110 can include a display area AA in which an image is displayed and a non-display area NA in which an image is not displayed. The non-display area NA can be an area outside the display area AA, and can also be referred to as a bezel area. The entirety or a part of the non-display area NA can be an area which is visible on the front surface of the display device 100 or an area which is bent and is not visible on the front surface of the display device 100.

The display panel 110 can include a substrate SUB and a plurality of subpixels SP which are disposed on the substrate SUB. In order to drive the plurality of subpixels SP, the display panel 110 can further include various types of signal lines.

The display device 100 according to the embodiments of the present disclosure can be a liquid crystal display device or the like, or can be a self-emissive display device in which the display panel 110 self-emits light. When the display device 100 according to the embodiments of the present disclosure is a self-emissive display device, each of the plurality of subpixels SP can include a light emitting element. But embodiments of the disclosure are not limited thereto.

For example, the display device 100 according to the embodiments of the present disclosure can be an organic light emitting display device in which a light emitting element is implemented by an organic light emitting diode (OLED). For another example, the display device 100 according to the embodiments of the present disclosure can be an inorganic light emitting display device in which a light emitting element is implemented by an inorganic-based light emitting diode. For still another example, the display device 100 according to the embodiments of the present disclosure can be a quantum dot display device in which a light emitting element is implemented by quantum dots as semiconductor crystals which self-emit light.

The structure of each of the plurality of subpixels SP can vary depending on the type of the display device 100. For example, when the display device 100 is a self-emissive display device in which each subpixel SP self-emits light, each subpixel SP can include a self-emissive light emitting element, at least one transistor and at least one capacitor. But embodiments of the disclosure are not limited thereto.

For example, the various types of signal lines can include a plurality of data lines DL which transfer data signals (also referred to as data voltages or image signals) and a plurality of gate lines GL which transfer gate signals (also referred to as scan signals).

The plurality of data lines DL and the plurality of gate lines GL can intersect each other. Each of the plurality of data lines DL can be disposed to extend in a first direction. Each of the plurality of gate lines GL can be disposed to extend in a second direction.

The first direction can be a column direction, and the second direction can be a row direction. The first direction can be a row direction, and the second direction can be a column direction.

The data driving circuit 120 as a circuit configured to drive the plurality of data lines DL can output data signals to the plurality of data lines DL. The gate driving circuit 130 as a circuit configured to drive the plurality of gate lines GL can output gate signals to the plurality of gate lines GL.

The display controller 140 can be a device configured to control the data driving circuit 120 and the gate driving circuit 130. The display controller 140 can control driving timing for the plurality of data lines DL and driving timing for the plurality of gate lines GL.

In order to control the data driving circuit 120, the display controller 140 can supply a data driving circuit control signal DCS to the data driving circuit 120. In order to control the gate driving circuit 130, the display controller 140 can supply a gate driving circuit control signal GCS to the gate driving circuit 130.

The display controller 140 can receive input image data from a host system 150, and can supply image data Data to the data driving circuit 120 on the basis of the input image data.

The data driving circuit 120 can supply data signals to the plurality of data lines DL according to the driving timing control of the display controller 140.

The data driving circuit 120 can receive the image data Data of a digital type from the display controller 140, can convert the received image data Data into data signals of an analog type, and can output the data signals to the plurality of data lines DL.

The gate driving circuit 130 can supply gate signals to the plurality of gate lines GL according to timing control of the display controller 140. The gate driving circuit 130 can be supplied with a first gate voltage corresponding to a turn-on level voltage and a second gate voltage corresponding to a turn-off level voltage along with various gate driving circuit control signals GCS, can generate gate signals, and can supply the generated gate signals to the plurality of gate lines GL.

For example, the data driving circuit 120 can be connected to the display panel 110 in a tape automated bonding (TAB) method, can be connected to bonding pads of the display panel 110 in a chip-on-glass (COG) or chip-on-panel (COP) method, or can be connected to the display panel 110 by being implemented in a chip-on-film (COF) method. But embodiments of the disclosure are not limited thereto.

The gate driving circuit 130 can be connected to the display panel 110 in a tape automated bonding (TAB) method, can be connected to bonding pads of the display panel 110 in a chip-on-glass (COG) or chip-on-panel (COP) method, or can be connected to the display panel 110 according to a chip-on-film (COF) method. Alternatively, the gate driving circuit 130 can be formed in the non-display area NA of the display panel 110 in a gate-in-panel (GIP) type. The gate driving circuit 130 can be disposed on the substrate SUB or can be connected to the substrate SUB. For example, in the case of the gate-in-panel (GIP) type, the gate driving circuit 130 can be disposed in the non-display area NA of the substrate SUB. In the case of the chip-on-glass (COG) type or the chip-on-film (COF) type, the gate driving circuit 130 can be connected to the substrate SUB.

At least one driving circuit of the data driving circuit 120 and the gate driving circuit 130 can be disposed in the display area AA of the display panel 110. For example, at least one driving circuit of the data driving circuit 120 and the gate driving circuit 130 can be disposed not to overlap the subpixels SP, or can be disposed to partially or entirely overlap the subpixels SP. But embodiments of the disclosure are not limited thereto.

The data driving circuit 120 can be connected to one side (e.g., the upper side or the lower side) of the display panel 110. Depending on a driving method, a panel design method, etc., the data driving circuit 120 can be connected to both sides (e.g., the upper side and the lower side) of the display panel 110, or can be connected to at least two sides of the four sides of the display panel 110.

The gate driving circuit 130 can be connected to one side (e.g., the left side or the right side) of the display panel 110. Depending on a driving method, a panel design method, etc., the gate driving circuit 130 can be connected to both sides (e.g., the left side and the right side) of the display panel 110, or can be connected to at least two sides of the four sides of the display panel 110.

The display controller 140 can be implemented as a component separate from the data driving circuit 120, or can be implemented as an integrated circuit by being integrated with the data driving circuit 120.

The display controller 140 can be a timing controller which is used in general display technology, can be a control device which includes a timing controller and is capable of further performing other control functions, can be a control device which is different from a timing controller, or can be a circuit in a control device. The display controller 140 can be implemented by various circuits or electronic parts such as an integrated circuit (IC), a field programmable gate array (FPGA), an application specific integrated circuit (ASIC) and a processor.

The display controller 140 can be electrically connected to the data driving circuit 120 and the gate driving circuit 130 through a printed circuit board (PCB), a flexible printed circuit board (FPCB) or the like.

The display controller 140 can transmit and receive signals to and from the data driving circuit 120 according to at least one predetermined interface. For example, the interface can include a low voltage differential signaling (LVDS) interface, an EPI interface, a serial peripheral interface (SPI), etc. But embodiments of the disclosure are not limited thereto.

Referring to FIG. 1, the display device 100 according to the embodiments of the present disclosure can include at least one optical area OA, such as a first optical area OA1 and a second optical area OA2, from which at least a portion of the substrate SUB is removed.

At least one component for providing various functions can be disposed in an area which at least partially overlaps the optical area OA. The at least one component can be, for example, an optical-electronic device, a clock hand, etc. But embodiments of the disclosure are not limited thereto.

For example, the optical-electronic device can include at least one of a photographing device such as a camera (an image sensor) and a detection sensor such as a proximity sensor and a light sensor. But embodiments of the disclosure are not limited thereto.

For example, a photographing device such as a camera can be located in the first optical area OA1, and a detection sensor can be located in the second optical area OA2. But embodiments of the disclosure are not limited thereto.

The component can be located under the substrate SUB to overlap at least partially the optical area OA.

The first optical area OA1 and the second optical area OA2 can have various shapes such as circular, oval, quadrangular, hexagonal and octagonal shapes. The shapes of the first optical area OA1 and the second optical area OA2 can be the same or different. The area of the first optical area OA1 can be the same as or different from the area of the second optical area OA2.

Hereinbelow, for the sake of convenience in explanation, description will be made on the assumption that the first optical area OA1 and the second optical area OA2 have circular shapes and the same area, but the present disclosure is not limited thereto.

The at least one optical area OA can be located in an area where the substrate SUB is removed. The optical area OA can be the non-display area NA in which a subpixel SP is not disposed.

The optical area OA located in the display area AA is also referred to as a "hole in display (HID)" or a "hole in active area (HiAA)."

Signal lines (e.g., the data lines DL and the gate lines GL) disposed on the substrate SUB can be disposed to detour (or bypass) the optical area OA.

In order to further provide a touch sensing function as well as an image display function, the display device 100 according to the embodiments of the present disclosure can include a touch sensor and a touch sensing circuit which, by sensing the touch sensor, detects whether a touch event has occurred by a touch object such as a finger or a pen or detects a touch position.

The touch sensing circuit can include a touch driving circuit 160 which generates and outputs touch sensing data by driving and sensing the touch sensor, and a touch controller 170 which is able to detect the occurrence of a touch event or detect a touch position using the touch sensing data.

The touch sensor can include a plurality of touch electrodes. The touch sensor can further include a plurality of touch lines for electrically connecting the plurality of touch electrodes and the touch driving circuit 160.

The touch sensor can exist in the form of a touch panel outside the display panel 110, or can exist inside the display panel 110.

In the case where the touch sensor exists in the form of a touch panel outside the display panel 110, the touch sensor can be referred to as an external type. When the touch sensor is an external type, the touch panel and the display panel 110 can be separately manufactured and be coupled during an assembly process. The external type touch panel can include a substrate for a touch panel and a plurality of touch electrodes on the substrate for a touch panel.

When the touch sensor exists inside the display panel 110, the touch sensor can be formed on the substrate SUB together with signal lines and electrodes related with display driving during the process of manufacturing the display panel 110.

The touch driving circuit 160 can supply a touch driving signal to at least one of the plurality of touch electrodes, and can generate touch sensing data by sensing at least one of the plurality of touch electrodes.

The touch sensing circuit can perform touch sensing in a self-capacitance sensing method or a mutual-capacitance sensing method.

In the case where the touch sensing circuit performs touch sensing in the self-capacitance sensing method, the touch sensing circuit can perform touch sensing on the basis of the capacitance between each touch electrode and a touch object (e.g., a finger, a pen, etc.).

According to the self-capacitance sensing method, each of the plurality of touch electrodes can serve as both a driving touch electrode and a sensing touch electrode. The touch driving circuit 160 can drive all or some of the plurality of touch electrodes, and can sense all or some of the plurality of touch electrodes.

In the case where the touch sensing circuit performs touch sensing in the mutual-capacitance sensing method, the touch sensing circuit can perform touch sensing on the basis of the capacitance between touch electrodes.

According to the mutual-capacitance sensing method, the plurality of touch electrodes are divided into driving touch electrodes and sensing touch electrodes. The touch driving circuit 160 can drive the driving touch electrodes and sense the sensing touch electrodes.

The touch driving circuit 160 and the touch controller 170 included in the touch sensing circuit can be implemented as separate devices or can be implemented as a single device. Further, the touch driving circuit 160 and the data driving circuit 120 can be implemented as separate devices or can be implemented as a single device.

The display device 100 can further include a power supply circuit which supplies various types of power to the display driving circuit and/or the touch sensing circuit.

The display device 100 according to the embodiments of the present disclosure can be a mobile terminal such as a smart phone and a tablet or a monitor or a television (TV) of various sizes. However, the display device 100 according to the embodiments of the present disclosure is not limited thereto, and can be a display device of various types and sizes capable of displaying information or an image.

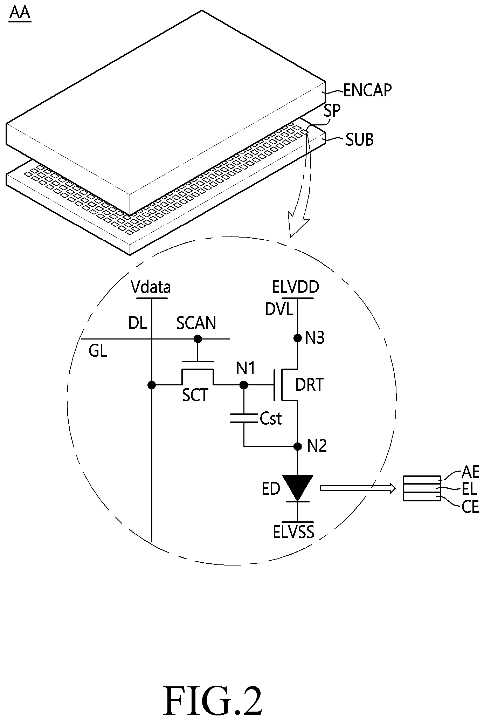

FIG. 2 is an equivalent circuit diagram of a subpixel SP in the display panel 110 according to the embodiments of the present disclosure. In the following description, the same or similar content to that described above with reference to FIG. 1 will be omitted or simply described.

Referring to FIG. 2, each of the subpixels SP disposed in the display area AA of the display panel 110 can include a light emitting element ED, a driving transistor DRT for driving the light emitting element ED, a scan transistor SCT for transferring a data voltage Vdata to a first node N1 of the driving transistor DRT, and a storage capacitor Cst for maintaining a constant voltage during one frame.

The driving transistor DRT can include the first node N1 to which the data voltage Vdata is applied, a second node N2 which is electrically connected to the light emitting element ED and a third node N3 to which a high potential common voltage ELVDD is applied from a driving voltage line DVL. In the driving transistor DRT, the first node N1 can be a gate node, the second node N2 can be any one node of a source node or a drain node, and the third node N3 can be the other node of the source node or the drain node.

The light emitting element ED can include an anode electrode AE as a first electrode, a light emitting layer EL and a cathode electrode CE as a second electrode. The anode electrode AE can be a pixel electrode which is disposed in each subpixel SP, and can be electrically connected to the second node N2 of the driving transistor DRT of each subpixel SP. The cathode electrode CE can be a common electrode which is disposed in common in the plurality of subpixels SP, and can be applied with a low potential common voltage ELVSS.

For example, the anode electrode AE can be a pixel electrode, and the cathode electrode CE can be a common electrode. Conversely, the anode electrode AE can be a common electrode, and the cathode electrode CE can be a pixel electrode. Hereinbelow, for the sake of convenience in explanation, it is assumed that the anode electrode AE is a pixel electrode and the cathode electrode CE is a common electrode. But embodiments of the disclosure are not limited thereto.

For example, the light emitting element ED can be an organic light emitting diode (OLED), an inorganic light emitting diode or a quantum dot light emitting element. When the light emitting element ED is an organic light emitting diode, the light emitting layer EL in the light emitting element ED can include an organic light emitting layer which includes an organic material.

The scan transistor SCT is on-off controlled by a scan signal SCAN which is a gate signal applied through a gate line GL. The scan transistor SCT can switch electrical connection between the first node N1 of the driving transistor DRT and a data line DL. But embodiments of the disclosure are not limited thereto.

The storage capacitor Cst can be electrically connected between the first node N1 and the second node N2 of the driving transistor DRT.

As illustrated in FIG. 2, each subpixel SP can have a 2T (transistor)1C (capacitor) structure including two transistors DRT and SCT and one capacitor Cst. As the case can be, each subpixel SP can further include at least one transistor or can further include at least one capacitor.

The storage capacitor Cst can be not a parasitic capacitor (e.g., Cgs or Cgd) which is an internal capacitor likely to exist between the first node N1 and the second node N2 of the driving transistor DRT but an external capacitor which is intentionally designed outside the driving transistor DRT.

Each of the driving transistor DRT and the scan transistor SCT can be an n-type transistor or a p-type transistor.

Because circuit elements (in particular, the light emitting element ED) in each subpixel SP are vulnerable to external moisture or oxygen, an encapsulation layer ENCAP for preventing external moisture or oxygen from penetrating into the circuit elements (in particular, the light emitting element ED) can be disposed in the display panel 110. The encapsulation layer ENCAP can be disposed in a shape which covers light emitting elements ED.

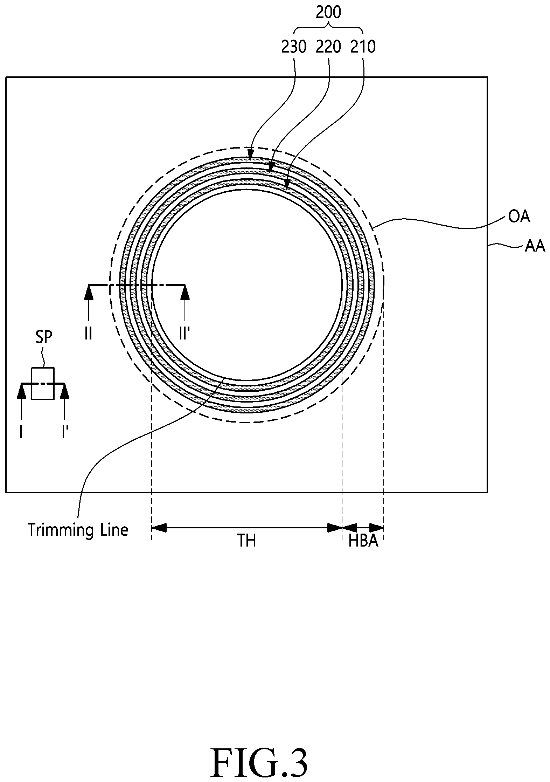

FIG. 3 is a plan view showing the structure of an optical area OA of the display panel 110 according to the embodiments of the present disclosure. In the following description, the same or similar content to that described above with reference to FIGS. 1 and 2 will be omitted or simply described.

Referring to FIG. 3, the optical area OA is disposed in the display area AA. Subpixels SP can be disposed around the optical area OA. The optical area OA can be any one of the first optical area OA1 or the second optical area OA2 described above.

Referring to FIG. 3, the optical area OA can include a through-hole TH and a bezel area which surrounds the through-hole TH. Such a bezel area located between the through-hole TH and the display area AA is also referred to as an "HiAA bezel area HBA."

The HiAA bezel area HBA is an area which surrounds the outside of the through-hole TH. The HiAA bezel area HBA can prevent interconnections from being damaged when irradiating laser for forming the through-hole TH. The HiAA bezel area HBA can be constantly maintained and have a minimum width.

In the HiAA bezel area HBA, a dam area 200 in which a dam structure for preventing penetration of moisture through a trimming line from the outside and micro cracks is disposed can be located. At least one dam can be disposed in the dam area 200. A subpixel SP for displaying an image may be not located in the optical area OA. For example, the optical area OA including the HiAA bezel area HBA can be the non-display area NA in which an image is not displayed.

The through-hole TH can be formed as the substrate SUB is removed along the trimming line. The through-hole TH can have a circular shape as shown in FIG. 3, but can have various shapes such as oval, quadrangular, hexagonal and octagonal shapes. But embodiments of the disclosure are not limited thereto.

The dam area 200 can include at least one dam. For example, in the dam area 200, a first dam 230, a second dam 220 and a third dam 210 can be disposed in order and be adjacent to the display area AA between the display area AA and the through-hole TH.

Each of the dams 210, 220 and 230 can have a closed curve shape which corresponds to the shape of the through-hole TH and surrounds the through-hole TH. The dams 210, 220 and 230 and the through-hole TH can have different closed curve shapes, but can have the same closed curve shapes which have different sizes. For example, the dams 210, 220 and 230 and the through-hole TH can have concentric circle shapes or be serially nested, and can be disposed to be spaced apart from each other by a predetermined interval. But embodiments of the disclosure are not limited thereto.

Each subpixel SP disposed in the display area AA can include a light emitting element. A light emitting stack including a light emitting layer can be located in the display area AA. When the light emitting element is an organic light emitting element, the light emitting stack can be an organic light emitting stack including an organic material. But embodiments of the disclosure are not limited thereto.

The organic light emitting stack can be disposed up to at least a partial area of the optical area OA.

When moisture penetrates into the organic light emitting stack, a defective phenomenon such as the dark spot of a subpixel can occur. In various instances, there is a possibility that moisture can penetrate into an area where the through-hole TH is located.

An inorganic encapsulation layer can be located on the dam area 200. Moisture can penetrate through the inorganic encapsulation layer, and the dam area 200 can have an effect of lengthening a path through which moisture penetrates through the inorganic encapsulation layer. According to this effect, the dam area 200 can prevent moisture introduced in the through-hole TH from reaching the light emitting layer located in the display area AA.

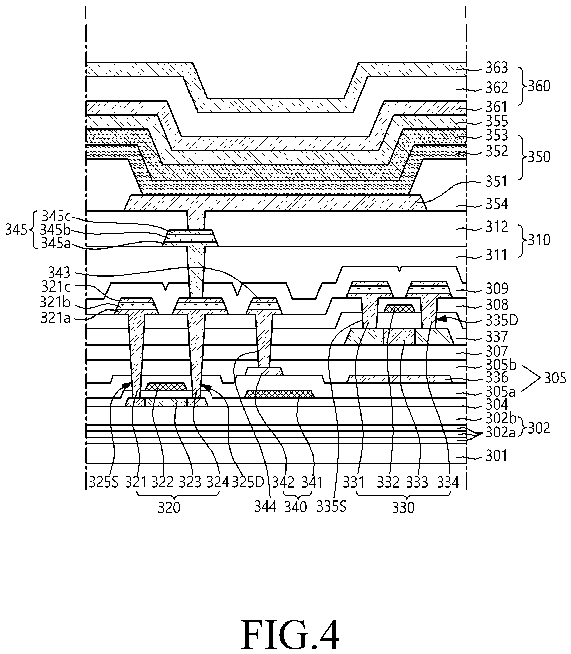

FIG. 4 is an example of a cross-sectional view taken along line I-I' of FIG. 3. For example, FIG. 4 is a view showing an example of the cross-sectional structure of the subpixel SP of FIG. 3. In the following description, the same or similar content to that described above with reference to FIGS. 1 to 3 will be omitted or simply described.

Referring to FIG. 4, the display device 100 according to the embodiments of the present disclosure can include a substrate 301. The substrate 301 can be a glass substrate or a plastic substrate. The plastic substrate can be made of or include, for example, polyimide (PI), polymethyl methacrylate (PMMA) or polyethylene (PE) to have flexible characteristics. But embodiments of the disclosure are not limited thereto.

A plurality of insulating layers can be provided on the substrate 301. A buffer layer 302 can be provided on the substrate 301. The buffer layer 302 can include a multi-buffer layer 302a and a lower buffer layer 302b. A first transistor 320 can be disposed on the lower buffer layer 302b. A first semiconductor layer 323 which constitutes the first transistor 320 can be disposed, and a lower gate insulating layer 304 for insulation from a first gate electrode 322 can be disposed on the first semiconductor layer 323. A lower interlayer insulating layer 305 can be disposed on the first gate electrode 322. As the lower interlayer insulating layer 305, a first lower interlayer insulating layer 305a and a second lower interlayer insulating layer 305b can be sequentially disposed. An upper buffer layer 307 can be disposed on the lower interlayer insulating layer 305. But embodiments of the disclosure are not limited thereto.

The multi-buffer layer 302a can delay the diffusion of moisture or oxygen penetrated into the substrate 301, and can be formed as silicon nitride (SiNx) and silicon oxide (SiOx) are alternately stacked at least once. But embodiments of the disclosure are not limited thereto.

The lower buffer layer 302b can protect the first semiconductor layer 323, and can perform the function of blocking various types of defects introduced from the substrate 301. The lower buffer layer 302b can be formed of amorphous silicon (a-Si), silicon nitride (SiNx) or silicon oxide (SiOx). But embodiments of the disclosure are not limited thereto.

The first semiconductor layer 323 of the first transistor 320 can be constituted by a polycrystalline semiconductor layer. But embodiments of the disclosure are not limited thereto. The first semiconductor layer 323 can include a channel area, a source area and a drain area.

The polycrystalline semiconductor layer has higher mobility than an amorphous semiconductor layer and an oxide semiconductor layer, resulting in low energy consumption and excellent reliability. Due to these advantages, a polycrystalline semiconductor layer can be used in a driving transistor. But embodiments of the disclosure are not limited thereto.

The first gate electrode 322 can be disposed on the lower gate insulating layer 304, and can be disposed to overlap the first semiconductor layer 323.

A second transistor 330 can be disposed on the upper buffer layer 307, and a light blocking layer 336 can be disposed below an area corresponding to the second transistor 330.

Referring to FIG. 4, the light blocking layer 336 can be disposed on the first lower interlayer insulating layer 305a below the area corresponding to the second transistor 330, and a second semiconductor layer 333 of the second transistor 330 can be disposed on the second lower interlayer insulating layer 305b and the upper buffer layer 307 to overlap the light blocking layer 336. An upper gate insulating layer 337 for insulating a second gate electrode 332 and the second semiconductor layer 333 can be disposed on the second semiconductor layer 333, and an upper interlayer insulating layer 308 can be disposed on the second gate electrode 332. The first gate electrode 322 and the second gate electrode 332 can be a single layer or a multilayer made of any one of molybdenum (Mo), aluminum (Al), chromium (Cr), gold (Au), titanium (Ti), nickel (Ni), neodymium (Nd) and copper (Cu) or an alloy thereof, but are not limited thereto.

The first and second lower interlayer insulating layers 305a and 305b can be formed as inorganic layers with a higher hydrogen particle content than the upper interlayer insulating layer 308. For example, the first and second lower interlayer insulating layers 305a and 305b can be made of silicon nitride (SiNx) formed through a deposition process using NH3 gas, and the upper interlayer insulating layer 308 can be formed of silicon oxide (SiOx). But embodiments of the disclosure are not limited thereto. Hydrogen particles included in the first and second lower interlayer insulating layers 305a and 305b can diffuse to the polycrystalline semiconductor layer during a hydrogenation process to fill voids in the polycrystalline semiconductor layer with hydrogen. Accordingly, the polycrystalline semiconductor layer can be stabilized to prevent the characteristics of the first transistor 320 from deteriorating.

After the activation and hydrogenation process of the first semiconductor layer 323 of the first transistor 320, the second semiconductor layer 333 of the second transistor 330 can be formed. The second semiconductor layer 333 can be formed of an oxide semiconductor. Since the second semiconductor layer 333 is not exposed to the high temperature atmosphere of the activation and hydrogenation process of the first semiconductor layer 323, damage to the second semiconductor layer 333 can be prevented to improve reliability.

After the upper interlayer insulating layer 308 is disposed, a first source contact hole 325S and a first drain contact hole 325D can be formed to correspond to the source and drain areas, respectively, of the first transistor 320, and a second source contact hole 335S and a second drain contact hole 335D can be formed to correspond to the source and drain areas, respectively, of the second transistor 330.

Referring to FIG. 4, the first source contact hole 325S and the first drain contact hole 325D can be formed continuously from the upper interlayer insulating layer 308 to the lower gate insulating layer 304, and the second source contact hole 335S and the second drain contact hole 335D can also be formed for the second transistor 330. A first source electrode 321 and a first drain electrode 324 corresponding to the first transistor 320 and a second source electrode 331 and a second drain electrode 334 corresponding to the second transistor 330 can be simultaneously formed, and through this, the number of processes for forming the source and drain electrodes of each of the first transistor 320 and the second transistor 330 can be reduced.

The first source and drain electrodes 321 and 324 and the second source and drain electrodes 331 and 334 can be a single layer or a multilayer made of any one of molybdenum (Mo), aluminum (Al), chromium (Cr), gold (Au), titanium (Ti), nickel (Ni), neodymium (Nd) and copper (Cu) or an alloy thereof, but the embodiments of the disclosure are not limited thereto.

The first source and drain electrodes 321 and 324 and the second source and drain electrodes 331 and 334 can have a triple-layer structure. The first source electrode 321 can be sequentially composed of a first electrode layer 321a, a second electrode layer 321b and a third electrode layer 321c.

The first electrode layer 321a, the second electrode layer 321b and the third electrode layer 321c can include materials with relatively different etch rates. The second electrode layer 321b can include a material with a relatively fast etch rate, and the first electrode layer 321a and the third electrode layer 321c can include a material with a relatively slow etch rate. For example, the second electrode layer 321b can include aluminum (Al) with a relatively fast etch rate, and the first electrode layer 321a and the third electrode layer 321c can include titanium (Ti) with a relatively slow etch rate. The first source electrode 321 can have a triple-layer structure of Ti/Al/Ti. But embodiments of the disclosure are not limited thereto.

The other source and drain electrodes can also have the same structure as the first source electrode 321.

A storage capacitor 340 can be disposed between the first transistor 320 and the second transistor 330. As shown in FIG. 4, the storage capacitor 340 can be formed as a storage lower electrode 341 and a storage upper electrode 342 overlap with the first lower interlayer insulating layer 305a interposed therebetween.

The storage lower electrode 341 can be located on the lower gate insulating layer 304, and can be formed of the same material at the same layer as the first gate electrode 322. The storage upper electrode 342 can be electrically connected to a pixel circuit through a storage supply line 343. The storage upper electrode 342 can be formed of the same material at the same layer as the light blocking layer 336. The storage upper electrode 342 is exposed through a storage contact hole 344 which passes through the second lower interlayer insulating layer 305b, the upper buffer layer 307, the upper gate insulating layer 337 and the upper interlayer insulating layer 308, to be connected to the storage supply line 343. Although the storage upper electrode 342 is spaced apart from the light blocking layer 336 as shown in FIG. 4, they can be integrally formed to be connected to each other. The storage supply line 343 can be formed of the same material on the same plane as the first source and drain electrodes 321 and 324 and the second source and drain electrodes 331 and 334. Due to this fact, the storage supply line 343 can be formed simultaneously with the first source and drain electrodes 321 and 324 and the second source and drain electrodes 331 and 334 using the same mask process.

As an inorganic insulating material such as SiNx or SiOx is deposited on the entire surface of the substrate 301 which is formed with the first source and drain electrodes 321 and 324, the second source and drain electrodes 331 and 334 and the storage supply line 343, a protective layer 309 can be formed. A first planarization layer 311 can be formed on the substrate 301 which is formed with the protective layer 309. Specifically, the first planarization layer 311 can be disposed as an organic insulating material such as acrylic resin is applied to the entire surface of the substrate 301 which is formed with the protective layer 309. But embodiments of the disclosure are not limited thereto.

After disposing the protective layer 309 and the first planarization layer 311, a contact hole which exposes the first source electrode 321 or the first drain electrode 324 of the first transistor 320 can be formed through a photolithography process. A connection electrode 345 can be disposed in the area of the contact hole which exposes the first drain electrode 324.

The connection electrode 345 can be a single layer or a multilayer made of any one of molybdenum (Mo), aluminum (Al), chromium (Cr), gold (Au), titanium (Ti), nickel (Ni), neodymium (Nd) and copper (Cu) or an alloy thereof, but embodiments of the disclosure are not limited thereto.

The connection electrode 345 can have a triple-layer structure. The connection electrode 345 can be sequentially composed of a first connection electrode layer 345a, a second connection electrode layer 345b and a third connection electrode layer 345c.

The first connection electrode layer 345a, the second connection electrode layer 345b and the third connection electrode layer 345c can include materials with relatively different etch rates. The second connection electrode layer 345b can include a material with a relatively fast etch rate, and the first connection electrode layer 345a and the third connection electrode layer 345c can include a material with a relatively slow etch rate. For example, the second connection electrode layer 345b can include aluminum (Al) with a relatively fast etch rate, and the first connection electrode layer 345a and the third connection electrode layer 345c can include titanium (Ti) with a relatively slow etch rate. The connection electrode 345 can have a triple-layer structure of Ti/Al/Ti. But embodiments of the disclosure are not limited thereto.

A second planarization layer 312 can be disposed on the connection electrode 345, and, by forming, in the second planarization layer 312, a contact hole which exposes the connection electrode 345, a light emitting element 350 which is connected to the first transistor 320 can be disposed.

The light emitting element 350 can include a first electrode 351 which is connected to the first drain electrode 324 of the first transistor 320, at least one light emitting stack 352 which is formed on the first electrode 351, and a second electrode 353 which is formed on the light emitting stack 352.

The light emitting stack 352 can include a hole injection layer, a hole transport layer, a light emitting layer, an electron transport layer and an electron injection layer. But embodiments of the disclosure are not limited thereto. In a tandem structure in which a plurality of light emitting layers overlap, a charge generation layer can be additionally disposed between a light emitting layer and a light emitting layer. In the case of the light emitting layer, there can be a case where the light emitting layer emits a different color for each subpixel. For example, a light emitting layer for red, a light emitting layer for green and a light emitting layer for blue can be formed separately for respective subpixels. However, a common light emitting layer can be formed to emit white light without color distinction in respective subpixels, and color filters to distinguish colors can be separately provided. By this, an RGB type (a real RGB type) and a WOLED (white OLED) can be classified. Each light emitting layer can be formed individually, but the injection layers and the transport layers can be provided as common layers to be disposed in the same manner in respective subpixels.

The first electrode 351 can be connected to the connection electrode 345 which is exposed through the contact hole passing through the second planarization layer 312. The first electrode 351 can be formed in a multilayer structure which includes a transparent conductive layer and an opaque conductive layer with high reflection efficiency. The transparent conductive layer can be made of a material with a relatively high work function value such as indium-tin-oxide (ITO) or indium-zinc-oxide (IZO), and the opaque conductive layer can be made of a single layer or multilayer structure including Al, Ag, Cu, Pb, Mo, Ti or an alloy thereof. But embodiments of the disclosure are not limited thereto. For example, the first electrode 351 can be formed as a structure in which a transparent conductive layer, an opaque conductive layer and a transparent conductive layer are sequentially stacked, or can be formed as a structure in which a transparent conductive layer and an opaque conductive layer are sequentially stacked. As the first electrode 351 is disposed on the second planarization layer 312 to overlap not only a light emitting area defined by a bank 354 but also a pixel circuit area where the first and second transistors 320 and 330 and the storage capacitor 340 are disposed, a light emission area can be increased. The first electrode 351 can be an anode electrode. But embodiments of the disclosure are not limited thereto.

The light emitting stack 352 can be formed as a hole transport layer, an organic light emitting layer and an electron transport layer are stacked on the first electrode 351 in that order or in the reverse order. The light emitting stack 352 can further include a charge generation layer, or can include first and second light emitting stacks which face each other with a charge generation layer interposed therebetween. But embodiments of the disclosure are not limited thereto.

The bank 354 can be formed to expose the first electrode 351. The bank 354 can be made of an organic material such as photo acrylic and can be a translucent material, but embodiments of the disclosure are not limited thereto and can be made of an opaque material to prevent light interference between subpixels. A spacer can be formed on the bank 354. The spacer can include an organic insulating material. The spacer can include the same material as the bank 354. The bank 354 and the spacer can be formed together in a mask process using a halftone mask or the like. In another embodiment, the spacer can include a material different from the bank 354.

The second electrode 353 can be formed on the upper surface of the light emitting stack 352 to face the first electrode 351 with the light emitting stack 352 interposed therebetween. When applied to a top emission type organic light emitting display device, the second electrode 353 can be formed as a transparent conductive layer by forming thin indium-tin-oxide (ITO), indium-zinc-oxide (IZO) or magnesium-silver (Mg-Ag). But embodiments of the disclosure are not limited thereto.

A capping layer 355 can be disposed on the second electrode 353.

The capping layer 355 can serve to protect the light emitting element 350 and help light generated in the light emitting stack 352 to be efficiently emitted to the outside. For example, the capping layer 355 can be made of an inorganic material or an organic material to prevent light emitted from the light emitting stack 352 to the outside from being lost through total reflection. The capping layer 355 can be made of an organic material or an inorganic material to prevent introduction of moisture and oxygen.

The capping layer 355 can include a single layer or a plurality of layers. For example, the capping layer 355 can be formed as a single layer of an organic capping layer including an organic material or an inorganic capping layer including an inorganic material, or can be formed as a plurality of layers as an organic capping layer and an inorganic capping layer are alternately deposited. When the capping layer 355 is formed as a plurality of layers, an organic capping layer and an inorganic capping layer can be sequentially formed on the second electrode 353. But embodiments of the disclosure are not limited thereto.

The organic capping layer can include the material of any one layer which constitutes the light emitting stack 352. For example, the organic capping layer can be formed using a material selected among the host material of the light emitting layer and a material which constitutes the hole transport layer or the electron transport layer, or can be formed using a separate organic material.

In order to increase the transmittance of light from the light emitting stack 352, the inorganic capping layer can be formed using a material such as LiF, LiO, MgF₂, NaF, CaO, KF, Bi₂S₃, Na₅Al₃F1₄ and SiO₂. But embodiments of the disclosure are not limited thereto.

An encapsulation layer 360 for protecting the light emitting element 350 can be formed on the capping layer 355. Due to the organic nature of the light emitting stack 352, the light emitting element 350 can react with external moisture or oxygen, resulting in a dark spot or a pixel shrinkage. In order to prevent this, the encapsulation layer 360 can be disposed on the capping layer 355.

The encapsulation layer 360 can have a single layer structure or a multilayer structure. For example, as shown in FIG. 4, the encapsulation layer 360 can include a first encapsulation layer 361, a second encapsulation layer 362 and a third encapsulation layer 363. But embodiments of the disclosure are not limited thereto.

The encapsulation layer 360 can include an inorganic layer which includes an inorganic insulating material. The encapsulation layer 360 can include an organic layer which includes an organic material. The encapsulation layer 360 can include an inorganic layer and an organic layer.

For example, the first encapsulation layer 361 and the third encapsulation layer 363 can be inorganic layers, and the second encapsulation layer 362 can be an organic layer. Among the first encapsulation layer 361, the second encapsulation layer 362 and the third encapsulation layer 363, the second encapsulation layer 362 can be thickest. According to this fact, the second encapsulation layer 362 can serve as a planarization layer. The first encapsulation layer 361 is also referred to as a first inorganic encapsulation layer, the second encapsulation layer 362 is also referred to as an organic encapsulation layer, and the third encapsulation layer 363 is also referred to as a second inorganic encapsulation layer. But embodiments of the disclosure are not limited thereto.

The first encapsulation layer 361 can be disposed on the capping layer 355, and can be disposed to be most adjacent to the light emitting element 350. The first encapsulation layer 361 can be formed of an inorganic insulating material capable of low temperature deposition. For example, the first encapsulation layer 361 can be silicon nitride (SiNx), silicon oxide (SiOx), silicon oxynitride (SiON) or aluminum oxide (Al₂O₃). But embodiments of the disclosure are not limited thereto. Since the first encapsulation layer 361 is deposited in a low temperature atmosphere, during a deposition process, the first encapsulation layer 361 can prevent the light emitting stack 352, which includes an organic material vulnerable to a high temperature atmosphere, from being damaged.

The second encapsulation layer 362 can be formed to have a smaller area than the first encapsulation layer 361. In this case, the second encapsulation layer 362 can be formed to expose both ends of the first encapsulation layer 361. The second encapsulation layer 362 can serve to perform a buffering function of relieving the stress between layers due to warpage of the display device 100, and can also serve to enhance planarization performance. The second encapsulation layer 362 can be referred to as a foreign matter compensation layer. For example, the second encapsulation layer 362 can include acrylic resin, epoxy resin, polyimide, polyethylene or silicon oxycarbon (SiOC), and can be formed of an organic insulating material. But embodiments of the disclosure are not limited thereto. For example, the second encapsulation layer 362 can be formed using an inkjet method.

The third encapsulation layer 363 can be formed on the substrate 301 formed with the second encapsulation layer 362 to cover the upper surface and the side surface of each of the second encapsulation layer 362 and the first encapsulation layer 361. The third encapsulation layer 363 can minimize or block external moisture or oxygen from penetrating into the first encapsulation layer 361 and the second encapsulation layer 362. For example, the third encapsulation layer 363 is formed of an inorganic insulating material such as silicon nitride (SiNx), silicon oxide (SiOx), silicon oxynitride (SiON) or aluminum oxide (Al₂O₃). But embodiments of the disclosure are not limited thereto.

The materials of the first encapsulation layer 361 and the third encapsulation layer 363 can be different from each other. The thicknesses of the first encapsulation layer 361 and the third encapsulation layer 363 can be different from each other. The thickness of the first encapsulation layer 361 can be larger than the thickness of the third encapsulation layer 363. Alternatively, the thickness of the third encapsulation layer 363 can be larger than the thickness of the first encapsulation layer 361, or the thicknesses of the first encapsulation layer 361 and the third encapsulation layer 363 can be the same as each other.

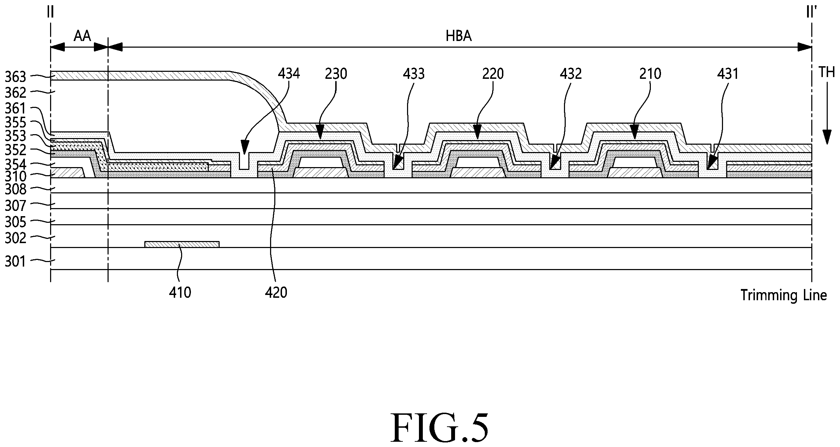

FIG. 5 is an example of a cross-sectional view taken along line II-II' of FIG. 3. For example, FIG. 5 is a view showing an example of the cross-sectional structure of the optical area OA of FIG. 3. In the following description, the same or similar content to that described above with reference to FIGS. 1 to 4 will be omitted or simply described.

Referring to FIGS. 3 and 5, in the display device 100 according to the embodiments of the present disclosure, the optical area OA can include the through-hole TH and the HiAA bezel area HBA, and the display area AA can be located outside the HiAA bezel area HBA. The HiAA bezel area HBA can be the non-display area NA.

Observing the cross-section of the HiAA bezel area HBA, various insulating layers which are present in the display area AA and the HiAA bezel area HBA can be disposed. For example, the buffer layer 302, the lower interlayer insulating layer 305, the upper buffer layer 307 and the upper interlayer insulating layer 308 can be sequentially stacked on the substrate 301. But embodiments of the disclosure are not limited thereto.

Referring to FIGS. 3 and 5, the dam area 200 including a "dam structure" such as a dam can be located between the display area AA and the through-hole TH.

The dam structure can have a layer structure of at least a double layer which is formed perpendicularly to the substrate 301. For example, the dam structure can include a first layer which is formed by the planarization layer 310 and a second layer which is formed by the bank 354. Specifically, the dam structure can include a first layer which is formed by the second planarization layer 312 and a second layer which is formed by the bank 354. The dam structure can include a first layer which is formed by the second planarization layer 312, a second layer which is formed by the bank 354 and a third layer which is formed by the spacer. The dam structure can have a structure which further includes the first planarization layer 311 under the second planarization layer 312 or is stacked to further include another layer. But embodiments of the disclosure are not limited thereto.

The dam area 200 can include at least one dam. For example, in the dam area 200, the first dam 230, the second dam 220 and the third dam 210 can be disposed in order adjacent to the display area AA between the display area AA and the through-hole TH.

Referring to FIG. 5, in the HiAA bezel area HBA which is the non-display area NA, the light emitting stack 352 can be disposed on the upper interlayer insulating layer 308 which is an insulating layer. The light emitting stack 352 can also be disposed on the dams 210, 220 and 230 disposed in the dam area 200. The light emitting stack 352 can be an organic light emitting stack. But embodiments of the disclosure are not limited thereto.

The second electrode 353 can extend from the display area AA to the HiAA bezel area HBA which is the non-display area NA, and can be disposed on the light emitting stack 352. The second electrode 353 can be a cathode electrode. But embodiments of the disclosure are not limited thereto.

An electrode patterning material layer 420 capable of improving light transmittance can be disposed in the HiAA bezel area HBA. The electrode patterning material layer 420 can be disposed on the light emitting stack 352, and can be disposed to contact one end of the second electrode and extend from one end of the second electrode 353 to the through-hole TH. One end of the electrode patterning material layer 420 and one end of the light emitting stack 352 can be disposed to coincide. But embodiments of the disclosure are not limited thereto.

The electrode patterning material layer 420 can be formed using an electrode patterning material (EPM) including an organic material. For example, the electrode patterning material layer 420 can be formed by depositing the electrode patterning material (EPM) using a fine metal mask (FMM) to cover at least a part of the HiAA bezel area HBA. For example, as the electrode patterning material, Ir(ppy)3 (Tris(2-phenylpyridine)iridium(III)) can be used. But embodiments of the disclosure are not limited thereto.

The electrode patterning material (EPM) can be used to improve the light transmittance of the optical area OA and at the same time effectively pattern the second electrode 353 formed on the entire surface of the display area AA and a part of the non-display area NA.

After forming the electrode patterning material (EPM) using the FMM in the optical area OA, by depositing the second electrode 353 on the entire surface of the display area AA and the part of the non-display area NA using an open metal mask (OMM), the second electrode 353 can be effectively formed on the entire surface of the display area AA and the part of the non-display area NA except the electrode patterning material (EPM). Accordingly, the electrode patterning material layer 420 and the second electrode 353 can be located on the same plane.

The thickness of the second electrode 353 can be not smaller than the thickness of the electrode patterning material layer 420. For example, the thickness of the second electrode 353 can be the same as the thickness of the electrode patterning material layer 420, or can be larger than the thickness of the electrode patterning material layer 420.

For example, in the case where a metal material as the second electrode 353 is entirely deposited after forming the electrode patterning material layer 420 by depositing the electrode patterning material (EPM) on the light emitting stack 352 of the optical area OA using the FMM, since the metal material is not deposited on the electrode patterning material layer 420, the second electrode 353 can be selectively formed only on the light emitting stack 352 of the entire surface of the display area AA and the part of the non-display area NA except the electrode patterning material layer 420. But embodiments of the disclosure are not limited thereto.

Since the electrode patterning material (EPM) can have a low surface energy by itself or can have a low adhesion characteristics so that the interfacial energy between the metal and the electrode patterning material layer 420 is high, when depositing the metal, the probability of desorption of the metal to occur on the surface of the electrode patterning material layer 420 is significantly increased, and nucleation of the metal does not occur. Therefore, as the metal is selectively deposited only in a high-adhesion area with relatively low interfacial energy, it is possible to form the self-aligned patterned metal.

Referring to FIG. 5, the light emitting stack 352 and the electrode patterning material layer 420 can be disposed by being sequentially stacked in the HiAA bezel area HBA. For example, the light emitting stack 352 and the electrode patterning material layer 420 can be disposed by being sequentially stacked on the dams 210, 220 and 230 located in the dam area 200. The light emitting stack 352 and the electrode patterning material layer 420 can be disposed by being sequentially stacked between the display area AA and the first dam 230. The light emitting stack 352 and the electrode patterning material layer 420 can be disposed by being sequentially stacked between the dams 210, 220 and 230 in the dam area 200. The light emitting stack 352 and the electrode patterning material layer 420 can be disposed by being sequentially stacked between the third dam 210 and the through-hole TH.

At least one groove can be disposed between the display area AA and the through-hole TH. The groove can be formed as each of the light emitting stack 352 and the electrode patterning material layer 420 is cut.

A groove 434 can be located between the display area AA and the dam area 200. For example, the groove 434 can be located between the display area AA and the first dam 230.

A groove can be located between dams. For example, a groove 433 can be located between the first dam 230 and the second dam 220, and a groove 432 can be located between the second dam 220 and the third dam 210.

A groove 431 can be located between the dam area 200 and the through-hole TH. For example, the groove 431 can be located between the third dam 210 and the through-hole TH.

The grooves 431, 432, 433 and 434 can be formed as each of the light emitting stack 352 and the electrode patterning material layer 420 is cut.

Referring to FIG. 5, when the grooves 431, 432, 433 and 434 are not formed, the light emitting stack 352 can be disposed to extend to the through-hole TH. Therefore, the light emitting stack 352 can become a lateral moisture penetration path on the cut surface of the through-hole TH, and a lifting phenomenon can occur due to moisture penetration.

Referring to FIG. 5, as the light emitting stack 352 is cut at the grooves 431, 432, 433 and 434, the moisture penetration path by the light emitting stack 352 can be blocked, and thus, lateral moisture penetration due to the lifting phenomenon can be prevented or reduced.

At the grooves 431, 432, 433 and 434, one end of the electrode patterning material layer 420 and one end of the light emitting stack 352 can be disposed to coincide. But embodiments of the disclosure are not limited thereto.

Referring to FIG. 5, the capping layer 355 can be disposed on the second electrode 353 and the electrode patterning material layer 420. The capping layer 355 can be cut at the grooves 431, 432, 433 and 434.

In other words, at the grooves 431, 432, 433 and 434, each of the light emitting stack 352, the electrode patterning material layer 420 and the capping layer 355 can be cut. At the grooves 431, 432, 433 and 434, one end of the light emitting stack 352, one end of the electrode patterning material layer 420 and one end of the capping layer 355 can be disposed to coincide.

The encapsulation layer 360 can be disposed on the capping layer 355.

The encapsulation layer 360 can contact the upper interlayer insulating layer 308, which is an insulating layer, without being cut at the grooves 431, 432, 433 and 434.

The encapsulation layer 360 can be a single layer or a multilayer.

For example, the encapsulation layer 360 can include a first encapsulation layer, a second encapsulation layer and a third encapsulation layer. The first encapsulation layer and the third encapsulation layer can be inorganic layers, and the second encapsulation layer can be an organic layer. Namely, the first encapsulation layer can be the first inorganic encapsulation layer 361, the second encapsulation layer can be the organic encapsulation layer 362, and the third encapsulation layer can be the second inorganic encapsulation layer 363.

The first inorganic encapsulation layer 361 can contact the upper interlayer insulating layer 308, which is an insulating layer, without being cut at the grooves 431, 432, 433 and 434.

The organic encapsulation layer 362 can be disposed between the first inorganic encapsulation layer 361 and the second inorganic encapsulation layer 363. The organic encapsulation layer 362 can be disposed between the display area AA and the first dam 230.

The first inorganic encapsulation layer 361 and the second inorganic encapsulation layer 363 can be disposed to contact each other around the first dam 230 and extend to the through-hole TH.

The first inorganic encapsulation layer 361 and the second inorganic encapsulation layer 363 can be disposed to be exposed to the through-hole TH.

Referring to FIG. 5, a lower shield metal 410 can be disposed between the substrate 301 and the buffer layer 302 which is an insulating layer.

One end of the lower shield metal 410 can be disposed to overlap the electrode patterning material layer 420, and the other end of the lower shield metal 410 can be disposed to overlap the second electrode 353. For example, the one end of the lower shield metal 410 can be located between one end of the second electrode 353 and the groove 434.

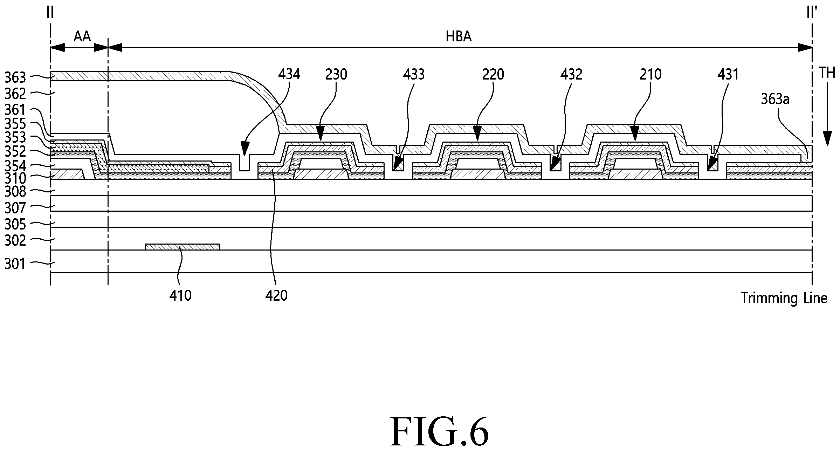

FIG. 6 is another example of the cross-sectional view taken along line II-II' of FIG. 3. For example, FIG. 6 is a view showing another example of the cross-sectional structure of the optical area OA of FIG. 3. In the following description, the same or similar content to that described above with reference to FIGS. 1 to 5 will be omitted or simply described.

Referring to FIG. 6, compared to the example of the cross-section shown in FIG. 5, there is only a difference in the disposition of the first inorganic encapsulation layer 361 and the second inorganic encapsulation layer 363 in the area of the through-hole TH, and thus, description of the other configurations will be omitted.

Referring to FIG. 6, the organic encapsulation layer 362 can be disposed between the first inorganic encapsulation layer 361 and the second inorganic encapsulation layer 363. The organic encapsulation layer 362 can be disposed between the display area AA and the first dam 230.

The first inorganic encapsulation layer 361 and the second inorganic encapsulation layer 363 can be disposed to contact each other around the first dam 230 and extend to the through-hole TH. The second inorganic encapsulation layer 363 can cover one end of the first inorganic encapsulation layer 361 at the through-hole TH. For example, one end 363a of the second inorganic encapsulation layer 363 can cover the one end of the first inorganic encapsulation layer 361 at the through-hole TH.

In various embodiments of the disclosure, the number, size, arrangement, and shapes of the grooves 431, 432, 433 and 434 can vary. For example, with reference to FIGS. 5 and 6, the number of the grooves can be 4 as shown, but embodiments of the disclosure are not limited thereto. For example, the number of the grooves can be greater than 4 or can be less than 4. In the embodiments shown in FIGS. 5 and 6, the number of the grooves 431, 432, 433 and 434 are provided as one more than the number of the dams 210, 220 and 230, but in other embodiments, the number of the grooves can be the same, greater than, or less than the number of the dams.

Additionally, sizes of the one or more of the grooves 431, 432, 433 and 434 can vary. For example, with reference to FIGS. 5 and 6, the size of each of the grooves 431, 432, 433 and 434 are shown as being less than a width of an interval between adjacent dams. For example, the groove 433 is shown as being narrower than the interval or a recess between the first dam 230 and the second dam 220. In this regard, the other grooves 434, 432 and 431 are shown as having the same or similar width or size. But embodiments of the disclosure are not limited thereto. For example, a width or a size of one or more of the grooves 431, 432, 433 and 434 can be the same as the interval or the recess between adjacent dams such as the first dam 230 and the second dam 220. In this instance, the groove 433 can extend from the planarization layer 310 at the first dam 230 to the planarization layer 310 at the second dam 220. One or more of the other grooves 434, 432 and 431 can have the same or similar width or size as that of the groove 433.

Additionally, arrangements of the one or more grooves 431, 432, 433 and 434 can vary. With reference to FIGS. 5 and 6, shown is one groove between adjacent dams. For example, between adjacent first dam 230 and second dam 220, there is one groove 433. But embodiments of the disclosure are not limited thereto. For example, there can be two or more grooves located between the first dam 230 and the second 220, as well as between the other dams. In other embodiments, any one of the grooves 431, 432, 433 and 434 can be formed as a plurality of grooves while the remainder are formed as a single groove. In other embodiments of the disclosure, there can be a plurality of grooves between a first pair of the dams, such as the first dam 230 and the second dam 220, but no groove between the second dam 220 and the third dam 210. In other embodiments of the present disclosure, grooves 434 and 431 can each be a plurality of grooves.

Additionally, the shapes of the grooves 431, 432, 433 and 434 can vary. With reference to FIGS. 3, 5 and 6, a shape in plane view of the grooves 431, 432, 433 and 434 can be circular or can correspond to a shape of the through-hole, but embodiments of the disclosure are not limited thereto. For example, the shape in plane view of one or more of the grooves 431, 432, 433 and 434 need not be a smooth curve, but can be wavy, or can have other shapes, such as a chevron shape, a square wave shape, semi-circular shapes, or others at one of an outer wall and an inner wall of the grooves 431, 432, 433 and 434, but embodiments of the disclosure are not limited thereto.

With reference to FIGS. 5, 6 and 7, the number, size, arrangement, and shapes of a sacrificial layer 440 can correspond to the number, size, arrangement, and shapes of the grooves 431, 432, 433 and 434.

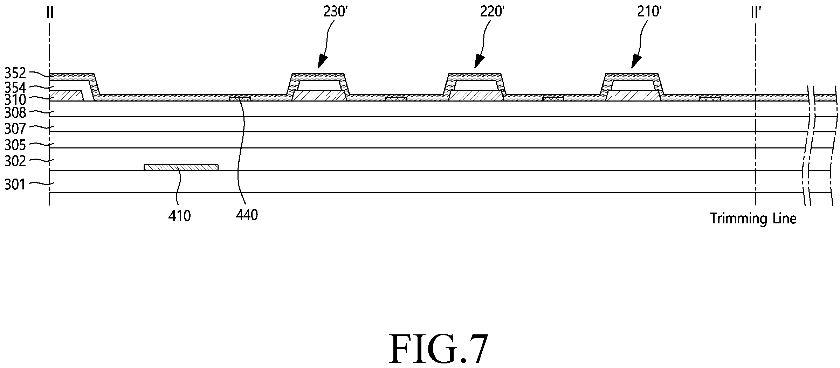

FIGS. 7, 8, 9, 10, 11, 12A and 12B are views showing a process of forming an optical area of a display panel according to embodiments of the present disclosure.

Referring to FIG. 7, a sacrificial layer 440 and dams 210', 220' and 230' can be formed on a substrate 301 in the non-display area NA.

For example, a lower shield metal 410 can be disposed on the substrate 301.

A plurality of insulating layers can be disposed on the substrate 301 and the lower shield metal 410. For example, a buffer layer 302, a lower interlayer insulating layer 305, an upper buffer layer 307 and an upper interlayer insulating layer 308 can be disposed. On the upper interlayer insulating layer 308, a planarization layer 310 can be formed by being patterned.

The sacrificial layer 440 can be formed by patterning a metal material on the upper interlayer insulating layer 308. The sacrificial layer 440 can be formed of the same material as a first electrode material. But embodiments of the disclosure are not limited thereto.

The dams 210', 220' and 230' can be formed by patterning a bank 354 on the planarization layer 310. A light emitting stack 352 can be formed on the bank 354, the upper interlayer insulating layer 308, the sacrificial layer 440 and the dams 210', 220' and 230', to cover the sacrificial layer 440 and the dams 210', 220' and 230'.

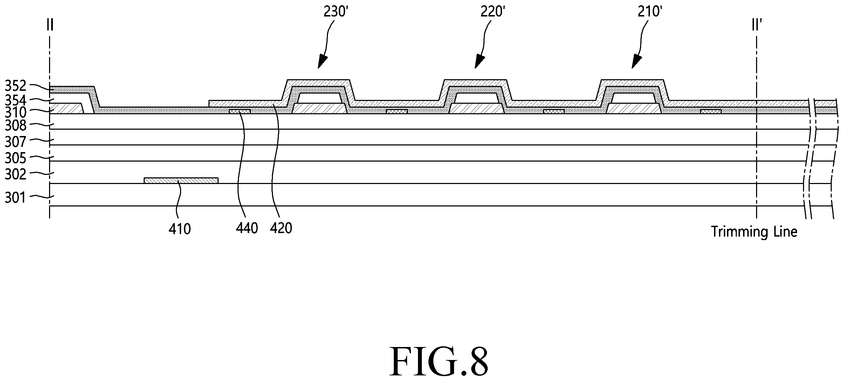

Referring to FIG. 8, an electrode patterning material layer 420 can be formed on the light emitting stack to be located in the HiAA bezel area HBA, which is the non-display area NA, using an electrode patterning material (EPM). The electrode patterning material (EPM) can be deposited using an FMM to cover at least a part of the HiAA bezel area HBA. The electrode patterning material layer 420 can be formed to overlap the lower shield metal 410.

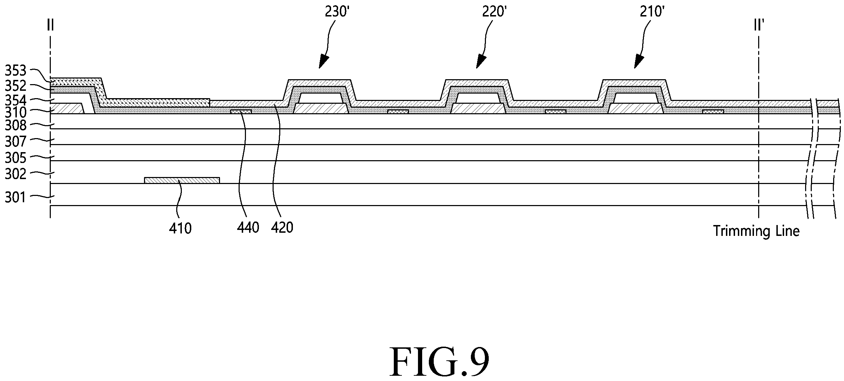

Referring to FIG. 9, a second electrode 353 can be formed on the light emitting stack 352 to contact the electrode patterning material layer 420, by depositing a metal on the entire surface of the display area AA and a part of the non-display area NA using an OMM. The second electrode 353 can be effectively formed on the entire surface of the display area AA and the part of the non-display area NA, which is an area excluding the electrode patterning material layer 420. Accordingly, the electrode patterning material layer 420 and the second electrode 353 can be located on the same plane.

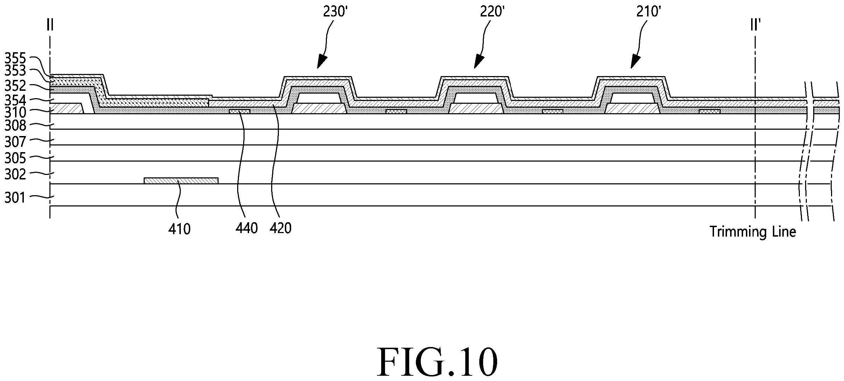

Referring to FIG. 10, a capping layer 355 can be formed, e.g., entirely, on the second electrode 353 and the electrode patterning material layer 420. But embodiments of the disclosure are not limited thereto.

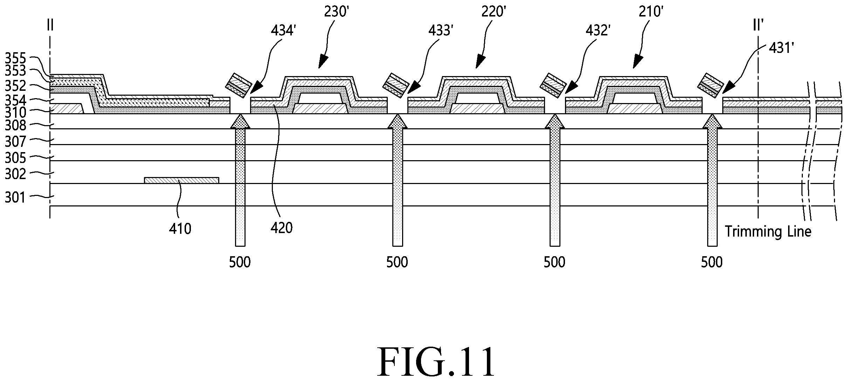

Referring to FIG. 11, grooves 43 1', 432', 433' and 434' can be formed by irradiating laser light 500 to the sacrificial layer 440 from the underside of the substrate 301. The laser light 500 can proceed from the lower surface of the substrate 301 in the thickness direction of the substrate 301, and can be irradiated to the lower surface of the sacrificial layer 440. The laser light 500 can have an infrared wavelength. But embodiments of the disclosure are not limited thereto. When the laser light 500 is infrared, the transmittance of the laser light 500 to the substrate 301 and the insulating layers 302, 305, 307 and 308 is high, and thus, the laser light 500 can efficiently reach the sacrificial layer 440.

The sacrificial layer 440 can absorb the laser light 500, and thermal expansion of the sacrificial layer 440 occurs. Therefore, the sacrificial layer 440 irradiated with the laser light 500 can be lifted off from the insulating layers 302, 305, 307 and 308.

As the sacrificial layer 440 is lifted off, the light emitting stack 352, the electrode patterning material layer 420 and the capping layer 355 which are disposed on the lifted-off sacrificial layer 440 can also be removed along with the sacrificial layer 440. Accordingly, the grooves 431', 432', 433' and 434' defined by openings of the light emitting stack 352, the electrode patterning material layer 420 and the capping layer 355 can be formed.

The lower shield metal 410 can be located between one end of the second electrode 353 and one end of the sacrificial layer 440. Since one end of the lower shield metal 410 is located between the one end of the second electrode 353 and the one end of the sacrificial layer 440, even when the laser light 500 is irradiated from the lower surface of the substrate 310, the lower shield metal 410 can prevent the laser light 500 from being irradiated to the second electrode 353. Accordingly, by decreasing the distance between the second electrode 353 and the grooves 431', 432', 433' and 434', the width of the HiAA bezel area HBA can be reduced.

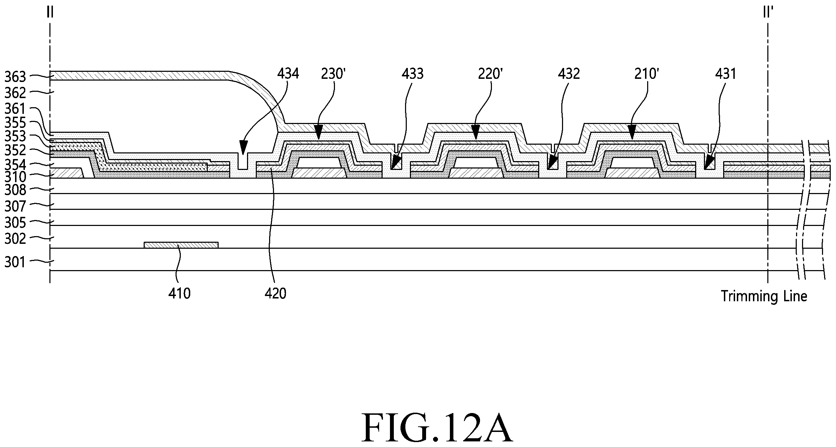

Referring to FIG. 12A, after forming the grooves 43 1', 432', 433' and 434', a first inorganic encapsulation layer 361, an organic encapsulation layer 362 and a second inorganic encapsulation layer 363 can be sequentially formed by being stacked. In this case, the first inorganic encapsulation layer 361 and the second inorganic encapsulation layer 363 can be formed to extend to the area of the through-hole TH. Thereafter, the through-hole TH can be formed with laser along a trimming line. The first inorganic encapsulation layer 361 and the second inorganic encapsulation layer 363 can be disposed to be exposed to the through-hole TH.

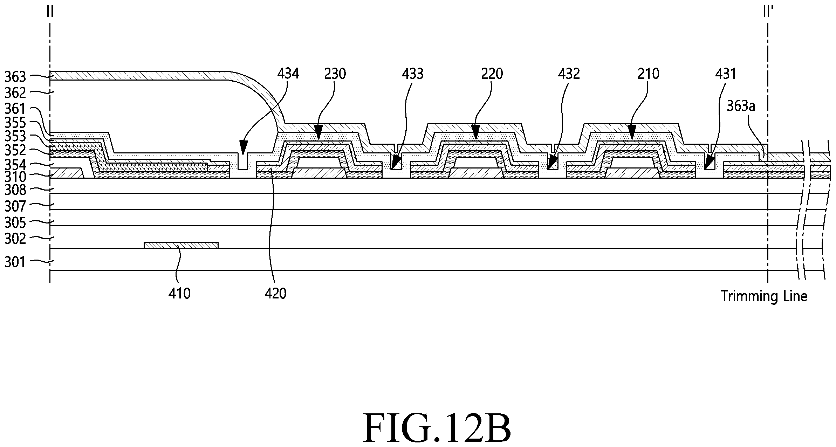

Referring to FIG. 12B, after forming the grooves 43 1', 432', 433' and 434', a first inorganic encapsulation layer 361, an organic encapsulation layer 362 and a second inorganic encapsulation layer 363 can be sequentially formed by being stacked. In this case, the first inorganic encapsulation layer 361 can be formed not to extend to the area of a through-hole TH, and the second inorganic encapsulation layer 363 can be formed to extend to the area of the through-hole TH to form an area 363a which surrounds the first inorganic encapsulation layer 361. Thereafter, the through-hole TH can be formed with laser along a trimming line. One end 363a of the second inorganic encapsulation layer 363 can be formed to cover one end of the first inorganic encapsulation layer 361 at the through-hole TH.

With reference to FIGS. 5 to 12B, once the sacrificial layer 440 is lifted off to remove the light emitting stack 352, the electrode patterning material layer 420 and the capping layer 355, portions of the upper interlayer insulating layer 308 are exposed at the grooves 431, 432, 433 and 434. Thereafter, once the first encapsulation layer 361 and the third encapsulation layer 363 are formed in the grooves 431, 432, 433 and 434, a sealing structure of a plurality of stacked inorganic layers is formed. The sealing structure can include two or more of the upper interlayer insulating layer 308, the first encapsulation layer 361 and the third encapsulation layer 363 that are in direct contact.

Two or more of the upper interlayer insulating layer 308, the first encapsulation layer 361 and the third encapsulation layer 363 can include or be formed of the same material, such as be silicon nitride (SiNx), silicon oxide (SiOx), silicon oxynitride (SiON) or aluminum oxide (Al₂O₃), but embodiments of the disclosure are not limited thereto.

In various embodiments of the disclosure, two or more of the grooves 431, 432, 433 and 434, when covered with the first encapsulation layer 361 and the third encapsulation, seals each sections of the light emitting stack 352, the electrode patterning material layer 420 and the capping layer 355 between the upper interlayer insulating layer 308 and the first encapsulation layer 361.

A brief description of the embodiments of the present disclosure described above is as follows.

According to embodiments of the present disclosure, a display device can include a substrate including a non-display area which includes a through-hole and a display area which is adjacent to (e.g., surrounds) the non-display area, an insulating layer disposed on the substrate, a light emitting stack disposed on the insulating layer, an electrode (herein also referred to as a second electrode) extending from the display area to the non-display area to be disposed on the light emitting stack, and an electrode patterning material layer contacting one end of the electrode, and disposed on the light emitting stack, wherein one end of the light emitting stack and one end of the electrode patterning material layer are disposed to coincide.

The display device according to one or more embodiments of the present disclosure can include a dam disposed between the display area and the through-hole.

In the display device according to one or more embodiments of the present disclosure, the light emitting stack and the electrode patterning material layer can be sequentially disposed on the dam.

The display device according to one or more embodiments of the present disclosure can include a groove located between the display area and the dam, each of the light emitting stack and the electrode patterning material layer being disconnected (e.g., cut) at the groove.

The display device according to one or more embodiments of the present disclosure can include a capping layer disposed on the electrode and the electrode patterning material layer.

In the display device according to one or more embodiments of the present disclosure, the capping layer can be disconnected (e.g., cut) at the groove.

In the display device according to one or more embodiments of the present disclosure, the dam can include a plurality of dams which are disposed to be spaced apart from each other.

In the display device according to one or more embodiments of the present disclosure, the plurality of dams can include a first dam and a second dam, and the display device can include a first groove located between the first dam and the second dam, each of the light emitting stack and the electrode patterning material layer being disconnected (e.g., cut) at the groove.

The display device according to one or more embodiments of the present disclosure can include a second groove located between the display area and the first dam, each of the light emitting stack and the electrode patterning material layer being disconnected (e.g., cut) at the second groove.

The display device according to one or more embodiments of the present disclosure can include a lower shield metal disposed between the substrate and the insulating layer, one end of the lower shield metal can overlap the electrode patterning material layer, and another end of the lower shield metal can overlap the electrode.

In the display device according to one or more embodiments of the present disclosure, the one end of the lower shield metal can be located between one end of the electrode and one end of the electrode patterning material layer.

The display device according to one or more embodiments of the present disclosure can include an encapsulation layer disposed on the capping layer, and the encapsulation layer may not be disconnected (e.g., cut) at the groove and may contact the insulating layer.

In the display device according to one or more embodiments of the present disclosure, the encapsulation layer can include a first inorganic encapsulation layer, an organic encapsulation layer and a second inorganic encapsulation layer, and the first inorganic encapsulation layer may not be disconnected (e.g., cut) at the groove and may contact the insulating layer.

In the display device according to one or more embodiments of the present disclosure, the first inorganic encapsulation layer and the second inorganic encapsulation layer can be exposed to the through-hole.

In the display device according to the embodiments of the present disclosure, the second inorganic encapsulation layer can cover one end of the first inorganic encapsulation layer at the through-hole.

In the display device according to the embodiments of the present disclosure, a thickness of the electrode may not be smaller than a thickness of the electrode patterning material layer.

According to embodiments of the present disclosure, a display device can include a substrate including a non-display area which includes a through-hole and a display area which is adjacent to (e.g., surrounds) the non-display area, an insulating layer disposed on the substrate, a plurality of dams located between the display area and the through-hole, and disposed on the insulating layer, a light emitting stack disposed on the insulating layer and the plurality of dams, an electrode (herein also referred to as a second electrode) extending from the display area to the non-display area to be disposed on the light emitting stack, an electrode patterning material layer contacting one end of the electrode, and disposed on the light emitting stack, and a groove at which each of the light emitting stack and the electrode patterning material layer is disconnected (e.g., cut).

In the display device according to one or more embodiments of the present disclosure, the groove can be disposed in at least one area among an area between the display area and the plurality of dams, an area between the plurality of dams and an area between the plurality of dams and the through-hole.

The display device according to one or more embodiments of the present disclosure can include a capping layer disposed on the electrode and the electrode patterning material layer, and the capping layer can be disconnected (e.g., cut) at the groove.

The display device according to one or more embodiments of the present disclosure can include a lower shield metal disposed between the substrate and the insulating layer, and one end of the lower shield metal can be located between one end of the electrode and one end of the electrode patterning material layer.

In the display device according to one or more embodiments of the present disclosure, an encapsulation layer can be disposed on the capping layer, the encapsulation layer can include a first inorganic encapsulation layer, an organic encapsulation layer and a second inorganic encapsulation layer, and the first inorganic encapsulation layer may not be disconnected (e.g., cut) at the groove and may contact the insulating layer.

In the display device according to one or more embodiments of the present disclosure, a thickness of the electrode may not be smaller than a thickness of the electrode patterning material layer.

According to embodiments of the present disclosure, a display device can include: a substrate including a non-display area having a through-hole and a display area adjacent to the display area; an inorganic insulating layer on the substrate; a light emitting stack on the inorganic insulating layer; a common electrode extending from the display area to the non-display area and disposed on the light emitting stack; an electrode patterning material layer contacting one end of the common electrode, and disposed on the light emitting stack; at least one groove formed in the light emitting stack and encircling the through-hole; and an inorganic encapsulating layer on the common electrode and in the at least one groove.

In the display device according to one or more embodiments of the present disclosure, the inorganic insulating layer and the inorganic encapsulating layer may be in direct contact in the at least one groove.

According to embodiments of the present disclosure, a method of manufacturing a display device can include forming a substrate including a display area and a non-display area, forming a sacrificial layer and a dam in the non-display area, forming a light emitting stack to cover the sacrificial layer and the dam, forming an electrode patterning material layer on the light emitting stack to be located in the non-display area, forming an electrode (herein also referred to as a second electrode) on the light emitting stack to contact the electrode patterning material layer, forming a capping layer on the second electrode and the electrode patterning material layer, and forming a groove by irradiating laser light to the sacrificial layer.

In the method of manufacturing a display device according to one or more embodiments of the present disclosure, in the forming of the groove, the light emitting stack can be cut at the groove.

In the method of manufacturing a display device according to one or more embodiments of the present disclosure, in the forming of the second electrode, the electrode can be formed at the same layer as the electrode patterning material layer.

The method of manufacturing a display device according to one or more embodiments of the present disclosure can include forming an encapsulation layer to cover the capping layer and the groove.

In the method of manufacturing a display device according to one or more embodiments of the present disclosure, in the forming of the encapsulation layer, the encapsulation layer can include a first inorganic encapsulation layer, an organic encapsulation layer and a second inorganic encapsulation layer, and the second inorganic encapsulation layer can be formed to cover the organic encapsulation layer and contact the first inorganic encapsulation layer.

In the method of manufacturing a display device according to one or more embodiments of the present disclosure, the second inorganic encapsulation layer can be formed to cover one end of the first inorganic encapsulation layer.

The display device and the method of manufacturing the same according to the embodiments of the present disclosure can block a lateral moisture penetration path due to the presence of a light emitting stack by patterning the light emitting stack.

The display device and the method of manufacturing the same according to the embodiments of the present disclosure can prevent or reduce a lateral moisture penetration path and micro cracks by a light emitting stack by patterning the light emitting stack and disposing a dam structure.

The display device and the method of manufacturing the same according to the embodiments of the present disclosure is capable of low power consumption by increasing lifespan by preventing or reducing lateral moisture penetration.

The above description has been presented to enable any person skilled in the art to make and use the technical idea of the present disclosure, and has been provided in the context of a particular application and its requirements. Various modifications, additions and substitutions to the described embodiments will be readily apparent to those skilled in the art, and the general principles defined herein can be applied to other embodiments and applications without departing from the scope of the present disclosure. The above description and the accompanying drawings provide an example of the technical idea of the present disclosure for illustrative purposes only. For example, the disclosed embodiments are intended to illustrate the scope of the technical idea of the present disclosure.

## Claims

1. A display device (100) comprising:
a substrate (301) including a non-display area (NA, OA) having a through-hole (TH) and a display area (AA) adjacent to the non-display area (NA, OA);
an insulating layer (308) disposed on the substrate (301);
a light emitting stack (352) disposed on the insulating layer (308);
an electrode (353) extending from the display area (AA) to the non-display area (NA, OA) and disposed on the light emitting stack (352); and
an electrode patterning material layer (420) contacting one end of the electrode (353), and disposed on the light emitting stack (352),
wherein one end of the light emitting stack (352) and one end of the electrode patterning material layer (420) are disposed to coincide.

2. The display device (100) of claim 1, further comprising:
a dam (210, 220, 230) disposed between the display area (AA) and the through-hole (TH).

3. The display device (100) of claim 2, wherein the light emitting stack (352) and the electrode patterning material layer (420) are sequentially disposed on the dam (210, 220, 230).

4. The display device (100) of claim 3, further comprising:
a groove (432, 433, 434) located between the display area (AA) and the dam (210, 220, 230), each of the light emitting stack (352) and the electrode patterning material layer (420) being disconnected at the groove (432, 433, 434).

5. The display device (100) of claim 4, further comprising:
a capping layer (355) disposed on the electrode (353) and the electrode patterning material layer (420).

6. The display device (100) of claim 5, wherein the capping layer (355) is disconnected at the groove (432, 433, 434).

7. The display device (100) of any of claims 2 to 6, wherein the dam (210, 220, 230) includes a plurality of dams (210, 220, 230) which are disposed to be spaced apart from each other.

8. The display device (100) of claim 7, wherein the plurality of dams (210, 220, 230) include a first dam (230) and a second dam (220), and
wherein the display device (100) further comprises:
a first groove (433) located between the first dam (230) and the second dam (220), each of the light emitting stack (352) and the electrode patterning material layer (420) being disconnected at the first groove (433);
wherein the display device, preferably, further comprises:
a second groove (434) located between the display area (AA) and the first dam (230), each of the light emitting stack (352) and the electrode patterning material layer (420) being disconnected at the second groove (434).

9. The display device (100) of any of claims 1 to 8, further comprising:
a lower shield metal (410) disposed between the substrate (301) and the insulating layer (308),
wherein one end of the lower shield metal (410) overlaps the electrode patterning material layer (420), and another end of the lower shield metal overlaps the electrode (353),
wherein, preferably, the one end of the lower shield metal (410) is located between one end of the electrode (353) and one end of the electrode patterning material layer (420).

10. The display device (100) of any of claims 5 to 8, or claim 9 referring back to claim 5, further comprising:
an encapsulation layer (361, 362, 363) disposed on the capping layer (355),
wherein the encapsulation layer (361, 362, 363) is not disconnected at the groove (432, 433, 434) and contacts the insulating layer (308).

11. The display device (100) of claim 10, wherein:
the encapsulation layer (361, 362, 363) comprises a first inorganic encapsulation layer (361), an organic encapsulation layer (362) and a second inorganic encapsulation layer (363), and
the first inorganic encapsulation layer (361) is not disconnected at the groove (432, 433, 434) and contacts the insulating layer (308).

12. The display device (100) of claim 11, wherein the first inorganic encapsulation layer (361) and the second inorganic encapsulation layer (363) are exposed to the through-hole (TH); or
wherein the second inorganic encapsulation layer (363) covers one end of the first inorganic encapsulation layer (361) at the through-hole (TH).

13. The display device (100) of any of claims 1 to 12, wherein a thickness of the electrode (353) is not smaller than a thickness of the electrode patterning material layer (420).

14. A method of manufacturing a display device (100), the method comprising:
forming a substrate (301) including a display area (AA) and a non-display area (NA, OA);
forming a sacrificial layer (440) and a dam (210', 220', 230') in the non-display area (NA, OA);
forming a light emitting stack (352) to cover the sacrificial layer (440) and the dam (210', 220', 230');
forming an electrode patterning material layer (420) on the light emitting stack (352) to be located in the non-display area (NA, OA);
forming an electrode (353) on the light emitting stack (352) to contact the electrode patterning material layer (420);
forming a capping layer (355) on the electrode (353) and the electrode patterning material layer (420); and
forming a groove (431', 432', 433', 434') by irradiating laser light (500) to the sacrificial layer (440).

15. The method of claim 14, wherein in the forming of the groove (431', 432', 433', 434'), the light emitting stack (352) is cut at the groove (43 1', 432', 433', 434'), and/or
wherein in the forming of the electrode (353), the electrode (353) is formed at the same layer as the electrode patterning material layer (420).

16. The method of claim 14 or 15, further comprising:
forming an encapsulation layer (361, 362, 363) to cover the capping layer (355) and the groove (431, 432, 433, 434).

17. The method of claim 16, wherein in the forming of the encapsulation layer (361, 362, 363), the encapsulation layer (361, 362, 363) comprises a first inorganic encapsulation layer (361), an organic encapsulation layer (362) and a second inorganic encapsulation layer (363), and the second inorganic encapsulation layer (363) is formed to cover the organic encapsulation layer (362) and contact the first inorganic encapsulation layer (361),
wherein, preferably, the second inorganic encapsulation layer (363) is formed to cover one end of the first inorganic encapsulation layer (361).
